# EUROPEAN PATENT APPLICATION

(11) **EP 1 289 010 A1**
(43) Date of publication of application: **05.03.2003**
(21) Application number: 01890248.6
(22) Date of filing: 29.08.2001
(51) Int. Cl.: H01L 23/31, H01L 21/56

(54) **Semiconductor device without use of chip carrier and method of making the same**

(71) Applicant: United Test Center Inc., Hsin-Chu (TW)
(72) Inventor: Bai, Jin Chuan, Sanchung, Taipei (TW)
(74) Representative: Haffner, Thomas M., Dr.

(57) **Abstract**

A semiconductor device without used of a chip carrier and method for making the same are proposed, in which a semiconductor chip has an active surface for disposing a plurality of conductive elements and forming a first encapsulant thereon, and a non-active surface for forming a second encapsulant thereon. The conductive elements are used to electrically connect the semiconductor chip to external devices. The first encapsulant is used to prevent the active surface from exposure to the atmosphere and encapsulate the conductive elements, for allowing one end of each of the conductive elements to be exposed to outside of the first encapsulant and coplanarly positioned with an outer surface of the first encapsulant. The second encapsulant together with the first encapsulant are able to provide sufficient structural strength for the semiconductor chip.

## Description

### FIELD OF THE INVENTION

The present invention relates to semiconductor devices, and more particularly, to a semiconductor device in which a semiconductor chip is electrically coupled to external devices by means of arrayed conductive elements.

### BACKGROUND OF THE INVENTION

In order to meet the requirement for reducing size, thickness and weight for electronic equipments such as Note Book, PDA or Set Top Box, it is not only necessary to improve the integration of components, but also important to downsize components assembled in the electronic equipments. Therefore, how to effectively reduce the height and the size of semiconductor devices serving as primary component in an electronic equipment has become a main issue in the present packaging industries.

Although the present semiconductor devices have been developed from a lead-frame-based package to a BGA (ball grid array) semiconductor device, then to a chip-scale-package (CSP) device, allowing the size of the semiconductor devices to be significantly reduced, there are still several problems existing in such CSP devices that need to be resolved. Firstly, when the semiconductor chip of a conventional CSP device is electrically connected to the substrate via bonding wires, bonding wires radially outwardly extend from the semiconductor chip onto the substrate which cause the overall height and the size of the conventional CSP device to be restricted by the height of the wire loop and the bonding area on the substrate where the bonding wires occupy; alternatively, when using flip chip technique for electrically connecting the semiconductor chip to the substrate by means of solder bumps, each of the solder bumps has a certain height, in addition to the total height of the solder ball mounted on the bottom surface of the substrate, the semiconductor chip and the substrate, making the overall height of the CSP device very difficult to be efficiently reduced. Moreover, when applying flip chip technique to electrically connect the semiconductor chip to the substrate of the CSP device, the overall packaging cost will increase and the manufacturing process will be accordingly more complicated, thereby making the desired yield difficult to achieve. Furthermore, the use of the substrate not only increases the overall height of the CSP device, but also makes the cost of CSP device difficult to reduce as the manufacturing cost of the substrate is high. Meanwhile, the semiconductor chip tends to suffer substantial thermal stress resulting from the substrate and the encapsulant during packing process, reliability test or operation when in use, as the semiconductor chip considerably differs in coefficient of thermal expansion from the substrate and the encapsulant that encapsulates the semiconductor chip. As a result, warpage and delamination may occur and thus affect the reliability of the product thus-obtained.

### SUMMARY OF THE INVENTION

A primary objective of the present invention is to provide a semiconductor device without use of a chip carrier and a method for making the same, in which the semiconductor device is made to be effectively reduced in overall thickness and size. Further, with no provision of the chip carrier, the semiconductor device can be cost-effectively fabricated and the method for making the semiconductor device can be simplified. Moreover, the semiconductor device is provided with an improved processing plan for allowing electrical connection of the semiconductor device to external devices to be assured. Furthermore, warpage or delamination can be prevented from occurrence due to sufficient mechanical strength of the semiconductor device. In addition, in the method for making the semiconductor device, the electricity and functionality tests to be performed at wafer level, thereby allowing the packaging process and the testing process to be simultaneously completed.

In accordance with the foregoing and other objectives, the present invention proposes a novel semiconductor device. The semiconductor device comprises a semiconductor chip having an active surface formed with electronic components and electronic circuits, and an opposing non-active surface; a plurality of conductive elements arranged on the active surface of the semiconductor chip for electrically connecting the semiconductor chip to external devices; a first encapsulant formed on the active surface in such a manner that the active surface of the semiconductor chip is prevented from exposure to the atmosphere, and the conductive elements are encapsulated with one end of each of the conductive elements being exposed to outside of the first encapsulant and coplanarly positioned with an outer surface of the first encapsulant; and a second encapsulant formed on the non-active surface of the semiconductor chip.

The conductive elements may be connecting bumps made of conductive metal such as copper, aluminum, the alloy thereof or the like. The conductive elements are bonded to bond pads formed on the active surface of the semiconductor chip by conventional printing methods, such as screen printing. As the bonding pads are electrically connected to the electric components and electric circuits on the active surface of the semiconductor chip, each of the conductive elements is electrically coupled to the semiconductor chip. The conductive elements may also be solder balls made of conductive metal such as aluminum. By the use of conventional solder ball implantation, the solder balls are bonded onto the active surface of the semiconductor chip and form an electrical connection between the semiconductor chip and each of the solder balls.

The methods for making the semiconductor device of the invention comprises the following steps: preparing a wafer having an active surface on which electronic components and electronic circuits are formed, and an opposing non-active surface; forming a plurality of conductive elements on the active surface of the wafer for electrically connecting a semiconductor chip to conductive elements; forming a first encapsulant on the active surface of the wafer in such a manner that the active surface of the wafer is kept from being in contact with the atmosphere, and that the conductive elements are encapsulated by the first encapsulant, with one end of each of the conductive elements being exposed to outside of the first encapsulant and coplanarly positioned with an outer surface of the first encapsulant; forming a second encapsulant on the non-active surface of the wafer; and singulating the combined structure of the wafer, the first encapsulant and the second encapsulant to form the semiconductor device.

In order to reduce the overall height of the semiconductor device formed by the above-mentioned method, a grinding process can be performed to grind the first encapsulant and the conductive elements toward the wafer until a desired thickness is reached. This grinding process can further improve the planarity of the plane formed by the ends of the conductive elements and the outer surface of the first encapsulant. Meanwhile, the non-active surface of the wafer can also be ground to reduce the thickness of the wafer, allowing the overall height of the packaged semiconductor device to be further lowered. As a result of sufficient mechanical support from the first encapsulant to the wafer, the grinding process does not lead to crack of the wafer. Similarly, the second encapsulant can also be ground after being formed on the non-active surface of the wafer, so that the thickness of the second encapsulant can be effectively reduced.

### BRIEF DESCRIPTION OF THE DRAWINGS

The present invention can be more fully understood by reading the following detailed description of the preferred embodiments, with reference made to the accompanying drawings, wherein:
FIG.1 is a sectional view of the semiconductor device in accordance with a first embodiment of the invention;
FIG. 2 is a sectional view of the semiconductor device in accordance with a first embodiment of the invention showing that a heat spreader is attached to a second encapsulant;
FIG. 3 is a sectional view of the semiconductor device in accordance with a second embodiment of the invention; and
FIGs. 4A-4G are schematic diagrams depicting the method for making the semiconductor device in accordance with a second embodiment of the invention.

### DETAIL DESCRIPTION OF THE PREFERRED EMBODIMENT

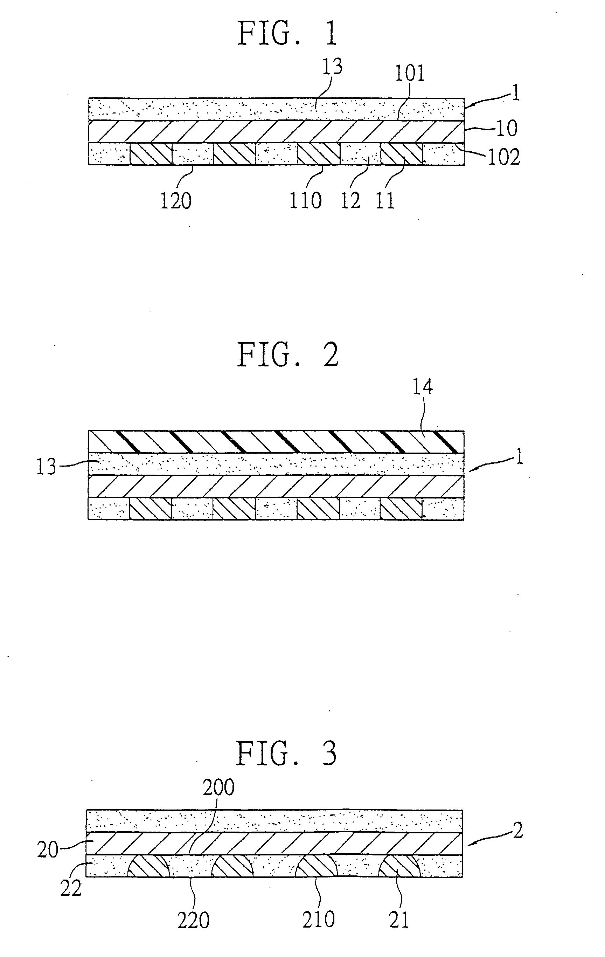

FIG. 1 illustrates a semiconductor device of a first embodiment of the invention. As shown in the drawing, the semiconductor device 1 includes a semiconductor chip 10 having an active surface 100 and an opposing non-active surface 101. A plurality of bond pads (not shown) are formed on the active surface 100 of the semiconductor chip 10, on which a plurality of connecting bumps 11 are bonded by a conventional printing method, allowing the semiconductor chip 10 to electrically connect external devices via the connecting bumps 11. The bond pads on the active surface 100 can also be re-distributed by a plurality of conductive traces to form connecting pads, which are electrically connected to the conductive traces, and function similarly to the bond pads in bonding the connecting bumps 11 thereon so as to establish the electrical connection of the semiconductor chip 10 to the external devices. Since the formation of the bond pads or connecting pads employs conventional technology, it will not be further shown in the drawing and described herein.

On the active surface 100 of the semiconductor chip 10 there is formed a first encapsulant 12 by a conventional resin compound such as epoxy resin. The first encapsulant 12 is used to prevent the active surface 100 of the semiconductor chip 10 from exposure to the atmosphere, in an effort to protect the active surface 10 of the semiconducter100 against atmospheric moisture and contaminants. The first encapsulant 12 is formed in a manner as to encapsulate the connecting bumps 11, wherein one end 110 of each of the connecting bumps 11 is exposed to outside of the first encapsulant 12 and coplanarly positioned with an outer surface 120 of the first encapsulant 12, thereby allowing the semiconductor device 1 to be electrically connected to an external device such as printed circuit board via the connecting bumps 11. Further, due to good coplanarity between the outer surface 120 of the first encapsulant 12 and the ends 110 of the connecting bumps 11, the connecting bumps 11 can be effectively connected to corresponding elements on the external device, so as to assure the quality for the electrical connection constructed between the semiconductor device 1 and the external devices by using a conventional SMT or reflow process. Moreover, as the first encapsulant 12 has a coefficient of thermal expansion (CTE) similar to that of the external device such as printed circuit board, the effect of CTE dismatch can be significantly reduced on electrically connecting the semiconductor device to the external device via the SMT or reflow process. In addition, since the ends 110 of the connecting bumps 11 are adapted to be planar, it facilitates the ends 110 to effectively come into contact with testing probes during a testing process, thereby making the testing accuracy desirably improved.

On the non-active surface 101 of the semiconductor chip 10 there is formed a second encapsulant 13 in a manner as to interpose the semiconductor chip 10 between the first encapsulant 12 and the second encapsulant 13. Such a sandwich structure provides appropriate support for the semiconductor chip 10, and makes the semiconductor device sufficient in structural strength with no use of a chip carrier such as a substrate or a lead-frame. Also, since the second encapsulant 13 and the first encapsulant 12 located respectively above and below the semiconductor chip 10 are both made of the same resin compound, thermal stresses generated from the encapsulants to the semiconductor chip 10 during a temperature cycle can substantially counteract each other. As a result, occurrence of warpage or delamination can be eliminated in the semiconductor device 1, and quality and reliability of packaged products can therefore be effectively improved.

Moreover, in no use of a substrate or a lead-frame, the semiconductor device 1 of the invention can be cost-effectively fabricated by a simplified process in a manner'as to miniaturize the semiconductor device 1 in profile, for allowing area thereof to be reduced to the size of the semiconductor chip 10. Furthermore, besides being electrically connected to an external device directly, the packaged product also can be externally connected to a substrate to form a flip chip semiconductor device.

In order to further improve the structural strength and heat dissipating efficiency for the semiconductor device 1, a heat spreader 14 can be attached to the second encapsulant 13, as shown in FIG. 2. Due to directly attachment of the heat spreader 14 to the second encapsulant 13, the provision of the heat spreader 14 is implemented according to practical requirements, without being restricted in thickness, shape, and size thereof.

FIG. 3 illustrates a semiconductor device of a second embodiment of the invention. The semiconductor device 2 of the second embodiment is structurally identical to that of the first embodiment, with the only difference in that solder balls 21 are used in the second embodiment in place of the connecting bumps 11 in the first embodiment, wherein the solder balls 21 are implanted on an active surface 200 of a semiconductor chip 20 by a conventional ball implantation process. In order to allow each of the solder balls 21 to be encapsulated by a first encapsulant 22 with one end 210 thereof being exposed to outside of the first encapsulant 22 and coplanarly positioned with an outer surface 220 of the first encapsulant 22, a grinding process is performed to grind off part of the first encapsulant 22 and part of the solder balls 21, thereby making the first encapsulant 22 reduced in thickness and the solder balls 21 decreased in height.

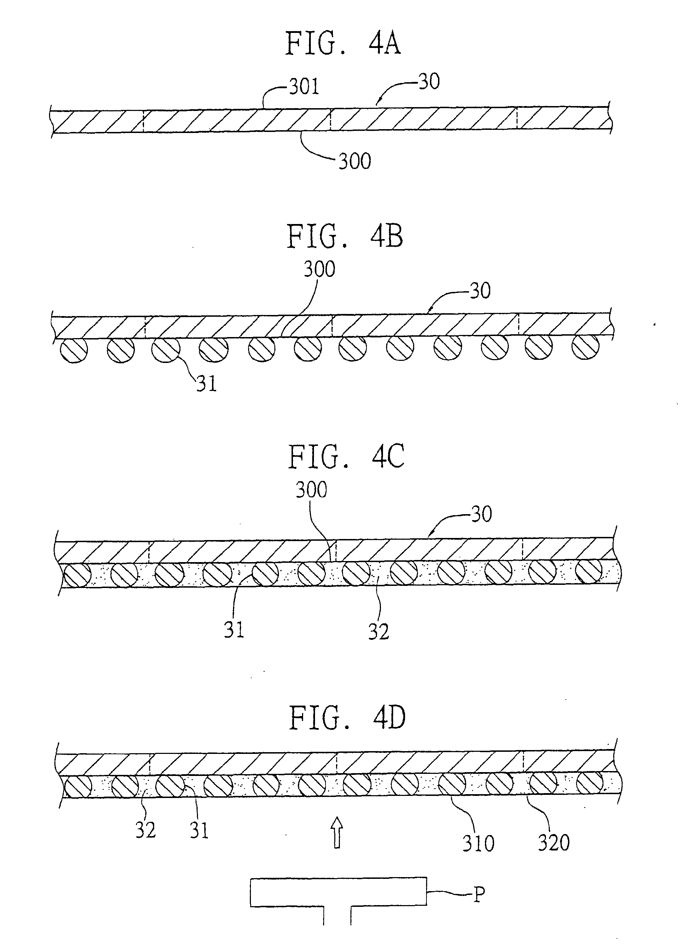

FIGs. 4A-4G illustrate the method for making the semiconductor device of the invention. As the method for making the semiconductor device of the invention is directly implemented on a wafer, elements in FIGs. 4A-4G are described with new labeled reference numerals in prevention of confusion with the foregoing embodiments.

Referring first to FIG. 4A, a wafer 30 having an active surface 300 and an opposing non-active surface 301 is provided. The wafer 30 can be cut along dotted lines (as shown in the drawing) to form a plurality of semiconductor chips.

Referring next to FIG. 4B, a plurality of solder balls 31 are implanted on the active surface 300 of the wafer 30 by a conventional ball implantation process, in a manner that the solder balls 31 are electrically connected to the semiconductor chip 30.

Referring further to FIG. 4C, a first encapsulant 32 is formed on the active surface 300 of the wafer 30, in a manner as to prevent the active surface 300 from exposure to the atmosphere and encapsulate the solder balls 31. The first encapsulant 32 is formed of epoxy resin by using a conventional technology such as an underfill process.

Referring to FIG. 4D, a grinding process is performed by using a grinding machine P to grind off part of the first encapsulant 32 and part of the solder balls 31, so as to reduce the thickness of the first encapsulant 32 and the height of the solder balls 31 respectively to a predetermined value. This is to make one end 310 of each of the solder balls 31 exposed the first encapsulant 32 and coplanarly positioned with an outer surface 320 of the first encapsulant 32, after completing the grinding process. However, the grinding process is not performed in the foregoing embodiment which employs the connecting bumps instead of the solder balls 31, since the connecting bumps and the first encapsulant can be controlled in height and thickness respectively in formation.

Referring to FIG. 4E, as the first encapsulant 32 provides sufficient mechanical support for the wafer 30, another grinding process can be performed by using the grinding machine P to grind the non-active surface 301 of the wafer 30. This reduces the thickness of the wafer 30 and further decrease the overall height of packaged products, without causing cracks for the wafer 30 or damage to electronic elements and electronic circuits formed on the active surface 300. In the case of the wafer to be formed in desired thickness or the thickness of the wafer not critical for product profile, this grinding process is not necessary.

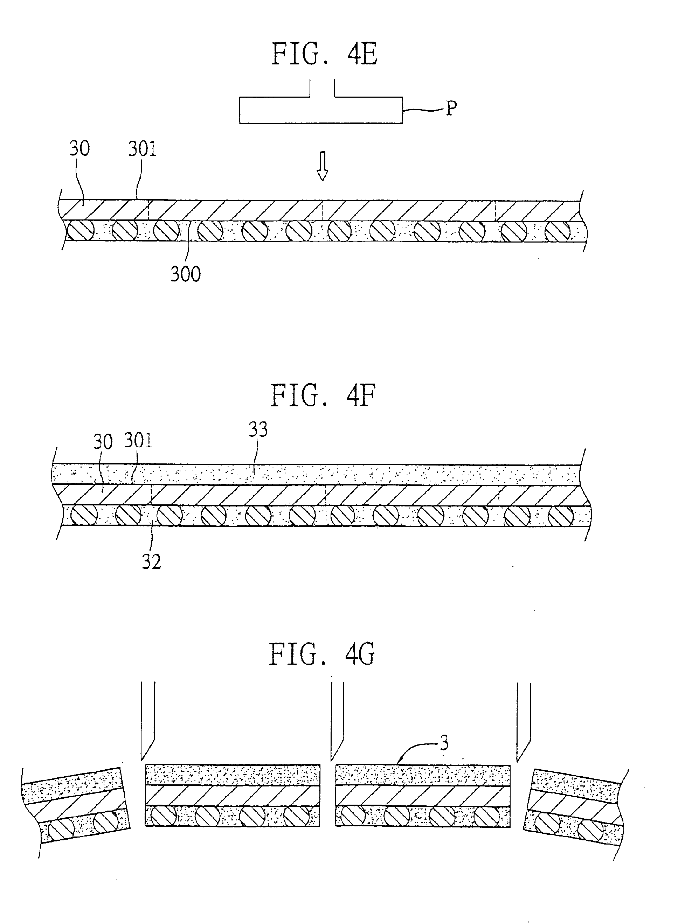

Referring to FIG. 4F, on the non-active surface 301 of the wafer 30 there is formed a second encapsulant 33 by epoxy resin, in a manner that the thickness of the second encapsulant 33, in accompany with the first encapsulant 32, can provide sufficient structural strength for the wafer 30. However, if the second encapsulant 33 can not be formed in desired thickness, a grinding process can then be performed to reduce the thickness thereof.

Referring finally to FIG. 4G, a singulation process is performed by employing a singulating machines to singulate combined structure of the first encapsulant 32, the wafer 30 and the second encapsulant 33 at predetermined positions, so as to form individual semiconductor devices 3.

In addition, the singulation process can be performed in an incomplete manner as to only singulate part of the combined structure, i.e. the first encapsulant 32 and the wafer 30, or the second encapsulant 33 and the wafer 30, so as to form incompletely singulated semiconductor devices 3, which can be subjected to electricity and functionality tests. As the incompletely singulated semiconductor devices 3 have the semiconductor chips formed by singulating the wafer 30 and separated from one another, cross-talk effect can be avoided during a high frequency test, and thus the test reliability can be assured. Alternatively, prior to forming the second encapsulant 33 on the non-active surface 301 of the wafer 30, the wafer 30 can be singulated in advance. This allows the high frequency test to be performed without cutting apart the first encapsulant 32 and the second encapsulant 33, and also prevents the cross talk effect from occurrence, after forming the second encapsulant 33.

The invention has been described using exemplary preferred embodiments. However, it is to be understood that the scope of the invention is not limited to the disclosed embodiments. On the contrary, it is intended to cover various modifications and similar arrangements. The scope of the claims, therefore, should be accorded the broadest interpretation so as to encompass all such modifications and similar arrangements.

## Claims

1. A semiconductor device, comprising:
a semiconductor chip having an active surface and an opposing non-active surface;
a plurality of conductive elements formed on the active surface of the semiconductor chip and electrically connected to the semiconductor chip;
a first encapsulant formed on the active surface of the semiconductor chip in a manner as to prevent the active surface from exposure to the atmosphere and encapsulate the conductive elements, wherein one end of each of the conductive elements is exposed to outside of the first encapsulant and coplanarly positioned with an outer surface of the first encapsulant; and
a second encapsulant formed on the non-active surface of the semiconductor chip.

2. The semiconductor device of claim 1, further comprising a heat spreader attached to the second encapsulant.

3. The semiconductor device of claim 1, wherein the conductive elements are connecting bumps made of conductive metal.

4. The semiconductor device of claim 1, wherein the conductive elements are solder balls made of conductive metal.

5. The semiconductor device of claim 1, wherein the first encapsulant and the second encapsulant are made of a resin compound.

6. A method for making a semiconductor device, comprising the steps of:
preparing a wafer having an active surface and an opposing non-active surface;
disposing a plurality of conductive elements on the active surface of the wafer, for electrically connecting the wafer to the conductive elements;
forming a first encapsulant on the active surface of the wafer in a manner as to prevent the active surface from exposure to the atmosphere and encapsulate the conductive elements, wherein one end of each of the conductive elements is exposed to outside of the first encapsulant and coplanarly positioned with an outer surface of the first encapsulant;
forming a second encapsulant on the non-active surface of the wafer; and
singulating combined structured of the first encapsulant, the wafer and the second encapsulant so as to form individual semiconductor devices.

7. The method of claim 6, wherein the conductive elements are connecting bumps made of conductive metal.

8. The method of claim 6, wherein the conductive elements are solder balls made of conductive metal.

9. The method of claim 6, after forming the first encapsulant on the active surface of the wafer, further comprising a step of:
grinding the first encapsulant and the conductive elements so as to reduce thickness of the first encapsulant and height of the conductive elements.

10. The method of claim 9, after grinding the first encapsulant and the conductive elements, further comprising a step of:
grinding the non-active surface of the wafer so as to reduce thickness of the wafer.

11. The method of claim 6, after forming the second encapsulant on the non-active surface of the wafer, further comprising a step of:
grinding the second encapsulant so as to reduce thickness of the second encapsulant.

12. The method of claim 6, after singulating the combined structure, further comprising a step of:
attaching a heat spreader to the second encapsulant.
